# EUROPEAN PATENT APPLICATION

(11) **EP 1 783 481 A1**
(43) Date of publication of application: **09.05.2007**
(21) Application number: 05256784.9
(22) Date of filing: 02.11.2005
(51) Int. Cl.: G01N 21/39, G01N 21/35, G01N 21/61, H01S 5/022

(54) **Laser radiation source**

(71) Applicant: Honeywell Analytics AG, 8610 Uster (CH)
(72) Inventor: Sutton, Stephen N, Honeywell Analytics, Ltd., Nuffield Estate Poole BH1 0RZ (GB); Watts, Rodney Royston, Honeywell Analytics, Ltd., Nuffield Estate Poole BH1 0RZ (GB)
(74) Representative: Hedley, Nicholas James Matthew

(57) **Abstract**

A transmitter unit is described for an open path gas detector. The unit comprises:
an enclosure (14) having a window (16); and
a coherent radiation transmitter (10), e.g. a tuneable laser diode transmitter, located within the enclosure and configured to direct a beam of radiation through the window.
The window is slanted with respect to the axis of the beam emitted by the transmitter such that no radiation from the transmitter that is directly incident on the window is reflected by the window directly onto the transmitter. Thereby interference fringes within the emitted radiation are reduced. Alternatively, the window may be replaced by a lens followed by an aperture such that the beam emitted by the transmitter is focused onto the aperture, thereby forming a beam of radiation passing out of the enclosure.

## Description

### Industrial Field

The present invention relates to the use of lasers as light sources. As used in the present specification, the term "light" is intended to cover electromagnetic radiation whether visible or not and in particular includes radiation in the infrared band. The present invention also relates to the use of such lasers in open path gas detectors for detecting gases; such detectors include a transmitter unit, which contains the laser and that transmits a beam of radiation across a path in the space being monitored and a detecting unit that detects the radiation that has passed across a space. The term "open path gas detector" is used to cover gas detectors irrespective of the length of the path and irrespective of whether the path is open to atmosphere conditions and/or is enclosed.

### Background Art

The use of non-dispersive infrared spectroscopy to detect hydrocarbon gases is well established. It essentially involves transmitting infrared radiation along a path in an area being monitored; the wavelength of the infrared radiation is chosen so that it is absorbed by the gas of interest (hereafter called the "target gas") but not substantially absorbed by other gases in the atmosphere of the area being monitored. If monitoring out-of-doors, the wavelength should ideally not be absorbed by liquid or gaseous water (e.g. in the form of humidity, condensation, fog, rain or spray). The intensity of the radiation that has passed along the path in the area being monitored is measured and the attenuation in the intensity of the radiation gives a measure of the amount of target gas in the monitored area.

It is known to monitor the presence of toxic gases in an atmosphere using point gas detectors, which can be electrochemical or optical (the term "toxic" gas in the context of the present specification means a gas or vapour other than one found generally in the atmosphere, e.g. oxygen, nitrogen, such as hydrogen sulphide, hydrogen fluoride, ammonia, sulphur dioxide, carbon dioxide and carbon monoxide). The provision of point gas detectors gives rise to problems when monitoring a large area since the placing of numerous detectors throughout the area is expensive. Furthermore, if the build up of target gas takes place between detectors, it will not be detected. Open path gas detectors with a path length in excess of 1 metre, typically at least 10m, allow a much larger area to be monitored by a single instrument.

The use of open path gas detectors has been made more attractive by the recent ready availability at a reasonable price of tuneable diode lasers (see GB-2353591), which can be tuned to a very narrow wavelength to detect characteristic absorbency wavelengths of a target gas. However, the levels of toxic gas that must be detected are low, and may typically be 5ppm (parts per million) and can be lower, e.g. 1ppm. At such low levels, the signal noise in the detector can be greater than the signal of the target gas, making it very difficult to detect such low levels of toxic target gases. In addition, the signal can become indiscernible due to drift in electronic or optical components over time, variations in temperature and/or atmospheric conditions, etc. In addition, the use of coherent laser irradiation from a tuneable laser diode can give rise to interference fringes where the variation in the intensity of the radiation between the bright and dark fringes far exceeds the signal arising from the presence of low levels of the target gas.

One particular source of interference fringes arises as a result of the interference between the main beam transmitted by a laser diode and a stray reflection of the same beam within the same optical system. Even very weak reflections can produce such fringes that have a difference between the light and dark fringes that exceed the signal produced by the target gas. Such interference fringes substantially limit the reliability of measurements using a laser light source.

When using laser diodes, it is necessary to enclose the laser in a small enclosure that is hermetically sealed from the external environment since moisture and atmospheric pollution can substantially reduce the life of a laser. The enclosure or cap containing the laser (which is often called a "package") can potentially reflect part of the light emitted by the laser and this reflected light can ultimately lead to interference fringes, as described above.

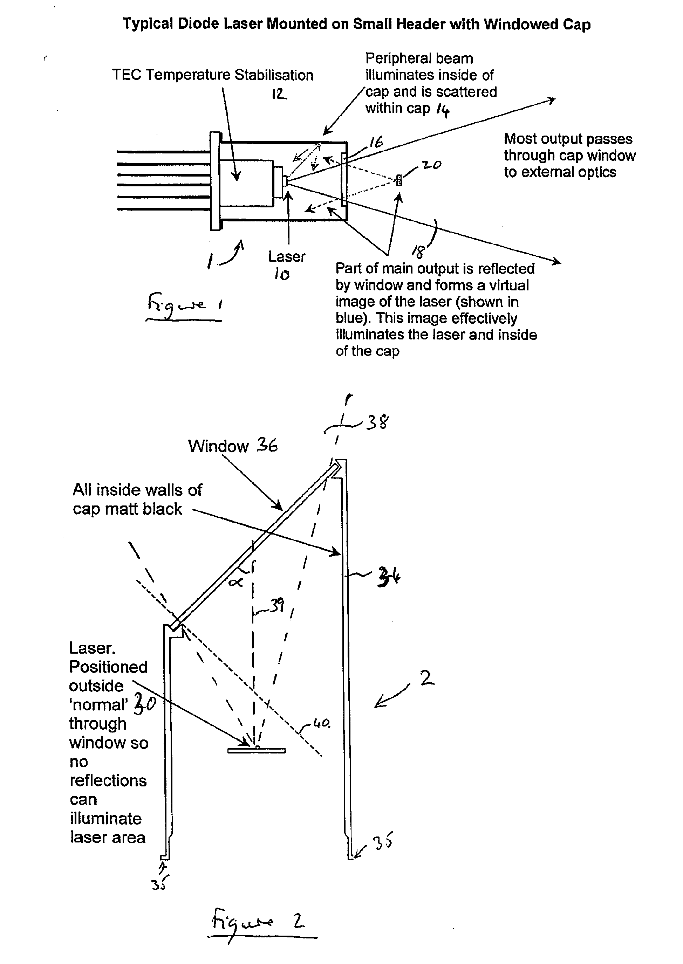

Referring to Figure 1, there is shown a typical tuneable laser diode package 1; it comprises a laser 10 that is mounted on a TEC temperature stabiliser 12 that holds the laser within a very narrow temperature range since the radiation wavelength output by the laser is temperature dependent. The laser and the temperature stabiliser are held within a cap or enclosure 14 that has a window 16 that allows a beam of radiation 18 emitted by the laser to be directed along its desired path. Most of the radiation passes through the window 16 but a fraction of the output illuminates the inside of the cap and is scattered within the cap, causing interference fringes within the radiation beam 18 emitted by the laser. In addition, we have found that another source of interference is the light reflected off the window, which can be envisaged as a weak source of coherent radiation located beyond the window at location 20. Again, this reflection causes interference fringes within the emitted beam 18. The amount of radiation reflected from the window 16 can be reduced by the use of antireflection coatings applied to the window but this does not eliminate completely this source of interference.

Accordingly, no low cost reliable open path gas detector for many toxic gases, i.e. those that exhibit weak absorption, at target gas levels as low as 10ppm has hitherto been possible.

### Disclosure of Invention

According to the present invention, there is provided a transmitter unit for an open path gas detector comprising
an enclosure having a window;
a coherent radiation transmitter, e.g. a tuneable laser diode transmitter, located within the enclosure and configured to direct a beam of radiation through the window,
wherein:
the transmitter and the window are so configured that no radiation from the transmitter that is directly incident on the window is reflected by the window directly onto the transmitter.

The window may be slanted with respect to the direction of the beam; for example the window may be slanted at an angle of 30 to 60°, e.g. about 45°, with respect to the axis of the beam. Given that the output of diode lasers is generally plane polarised, it is possible to minimise reflections from the surface by selecting the angle near to Brewster's angle (which is typically about 57° for common glasses of refractive index 1.5). Provided the orientation of the window is correctly chosen with respect to the plane of polarization of the laser output, then the transmission through the window can be maximised (to near unity) by this means. However, it is not possible to completely eliminate reflections by this technique since there will always be a range of angles passing through the window and only light that is incident on the window at exactly Brewster's angle will be transmitted without any reflection and at slightly less or greater angles, some reflection will occur at the surface. The angle is preferably not too great since that can lead to distortion of the beam. The smaller the angle is, the further away from the window the transmitter must be placed in order to avoid interference fringes caused by the reflection of the transmitter in the window, which can result in the beam being too narrow, as explained in further detail below. In order to increase the width of the beam, the transmitter may be located behind a shield that is opaque at the wavelength of the radiation transmitter and that is located to block radiation passing out of part of the front of the enclosure.

The surfaces inside the enclosure that are not required to form or transmit the beam are matt black to absorb scattered radiation. The term "matt black" refers to a surface that reflects a minimum amount of incident light directed at it and further, where such reflections do occur, they are spread over a wide range of angles rather than following normal reflection rules that apply to mirror surfaces.

According to a second aspect of the present invention, there is provided a transmitter unit for an open path gas detector that is configured to transmit a beam of radiation, the unit comprising
an enclosure having an aperture providing an optical path between the interior and the exterior of the enclosure,
a transmitter of coherent radiation, e.g. a tuneable laser diode transmitter, located within the enclosure, and
an optical device located within the enclosure that is configured to receive the radiation emitted by the transmitter and focus it on the aperture, thereby forming a beam of radiation passing out of the enclosure.

The diameter of the aperture is beneficially chosen such that substantially all the radiation beam from the transmitter is collected by the optical device and directed through the aperture, so that substantially no radiation impinges on the inside surface of the enclosure to cause interference fringes. The smaller the diameter, the less the chance is that stray radiation from outside the enclosure will enter the enclosure through the aperture, thereby causing interference. The diameter will typically be less than 200 µm, e.g. less than 100 µm, such as about 50µm but smaller diameters should be provided if the quality of the optical device and the accuracy of the alignment of the aperture with the optical device allows.

The optical device may be a lens or a mirror.

This arrangement has two substantial advantages. Firstly, none of the radiation produced by the radiation source is incident on an internal wall within the laser and so there are no reflections that can cause interference.

Furthermore, the use of the lens provides the possibility of altering the divergence angle of the beam emitted by the laser package, which can improve the coupling of the laser output to the external optics.

### Description of the Drawings

There will now be described by way of example only embodiments according to the two aspects of the present invention with reference to the accompanying drawings in which:
Figure 1 is a side view of a prior art laser diode package with part of the enclosure cut away;
Figure 2 is a side view of a laser diode package according to the first aspect of the present invention with part of the enclosure cut away;
Figure 3 is a side view of a variant of the laser diode package shown in Figure 2;
Figure 4 is a side view of a laser diode package according to the second aspect of the present invention with part of the enclosure cut away.

### Detailed Description of the Best Mode for Putting the Invention into Operation

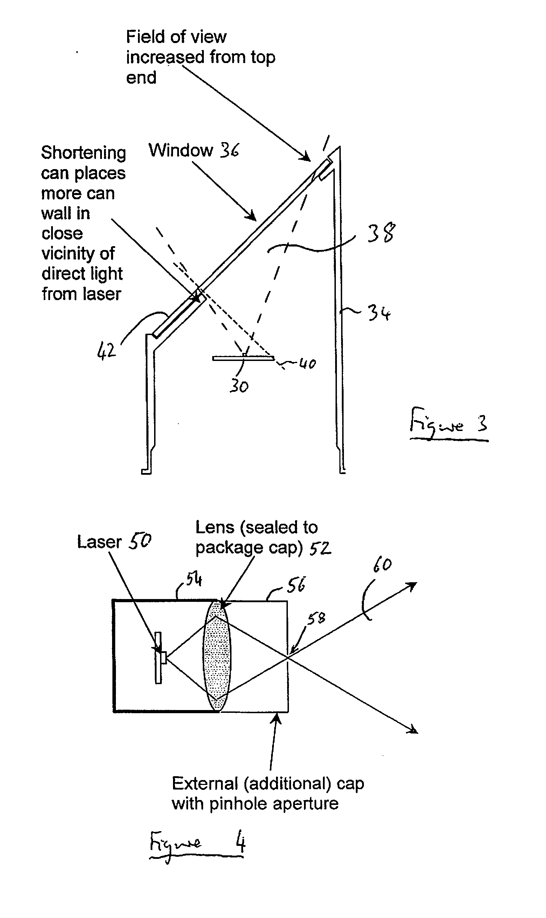

Referring to Figure 2, there is shown a package 2 similar to that of Figure 1 but the TEC temperature stabiliser has been omitted and the front part only of the enclosure 34 is shown; the front part of the enclosure has connectors 35 that enables the enclosure 34 to be connected to a base to seal the space within the enclosure 34.

The enclosure or cap 34 has a window 36 that allows a beam of radiation 38 emitted by the laser 30 to be directed along a desired path. The window is at an angle α of about 45° with respect to the axis 39 of the beam. The laser diode 30 is located in a position such that it is not located on any orthogonal to the window 36. One such orthogonal is shown by the reference numeral 40. This means that no radiation from the diode that is directly incident on the window 36 can be reflected by the window back onto the transmitter, causing interference. Put another way, any image of the transmitter reflected in the window is not located in the beam 38 transmitted through the window, which would cause interference.

The arrangement shown in Figure 2 requires a long enclosure can 34 to achieve this condition, the approximate length would be 15mm for typical laser enclosure sizes (for example a TO5 size can).

An alternative arrangement is shown in Figure 3; the same reference numbers as used in connection with Figure 2 are used in Figure 3 to indicate the same features. In the case of Figure 3, part of the front of the enclosure 34 is covered by an opaque matt black shield 42 so that the transmitter 30 still lies beyond the orthogonal 40 to the window 36. Because of the shield 42, the enclosure can 34 can be made shorter (perhaps 11 or 12mm). The shorter version of Figure 3 also offers a slightly wider beam 38 as compared to the longer version of Figure 2. However, it does suffer from the disadvantage over Figure 2 that radiation can be reflected off the shield and cause interference; the matt black surface of the shield is intended to absorb radiation and hence reduce such reflections.

The second aspect of the present invention is based on the arrangement of Figure 1 except that the window 16 is replaced by a lens 52. This lens is such as to project an image of the inside of the laser 50 to a region just in front of the lens. An additional cap 56 is precisely located on the outside of the package 54 (making a compound or 2 compartment package). This external cap has a small (about 50 micron) hole 58 in it that is precisely located so that the image of the laser formed by the lens lies in the hole 58. Provided the lens 52 is small it will couple very accurately with the laser and any distortions (blurring) of the image will be small. The use of a more complex lens design (aspheric) may further enhance the quality of the image produced and so allow a smaller apertured hole 58 and so facilitate better elimination of stray light within the main enclosure 54.

With the arrangement of Figure 4, the internal illumination of the inside of the enclosure 54 by the laser 50 will not be focused on the hole 58 and so will not cause interference fringes in the beam 60 emitted by the package. Also there is now no reflecting surface beyond the aperture (except the main body of the instrument enclosure or the external optics).

The approach in Figure 4 has two further advantages. Firstly, when using certain types of diode lasers (Distributed FeedBack lasers or DFB) the design of the laser generally produces emissions from the rear of the laser that will directly illuminate the area behind the laser itself. This rear emission has the capability of generating interference fringes. The use of a lens 52 and pinhole 58 as described here will effectively limit the extent of any coupling to this rear emission by the external optics of an open path gas detector.

Secondly, the use of the lens provides the possibility of altering the divergence of the output beam 60. This is achieved by varying the ratio of the object/image distance (i.e. the distance from the laser 50 to the lens 52 and from the lens 52 to the image of the laser at the pinhole 58). This can provide the possibility of improving the coupling of the laser output to the external optics or of simplifying or reducing the size of the external optics required.

With the arrangement of Figure 4, the external cap 56 with the pinhole 58 must be precisely located and fixed to the main enclosure 54. This operation requires accurate alignment of the pinhole 58 with the image of the laser. The precision required for this operation is likely to be of the order of 10% of the diameter of the pinhole 58 or better; however, alignment and fixing to this accuracy is routinely achieved in the open path gas detector field (e.g. using conventional and inexpensive micrometer adjustment equipment).

## Claims

1. A transmitter unit for an open path gas detector comprising
an enclosure (14) having a window (16);
a coherent radiation transmitter (10), e.g. a tuneable laser diode transmitter, located within the enclosure and configured to direct a beam
of radiation through the window,
wherein:
the transmitter and the window are so configured that no radiation from the transmitter that is directly incident on the window is reflected by the window directly onto the transmitter.

2. A transmitter as claimed in claim 1, wherein the window is slanted with respect to the direction of the beam.

3. A transmitter as claimed in claim 2, wherein the window is slanted at an angle of 30 to 60° with respect to the axis of the beam.

4. A transmitter as claimed in any preceding claim, wherein:
the enclosure includes a front that comprises the window;
the transmitter includes a shield that is opaque at the wavelength of the radiation transmitter and that is located to block radiation passing out of part of the front of the enclosure and the transmitter is located behind the shield.

5. A transmitter as claimed in any preceding claim, wherein the surfaces inside the enclosure that are not required to form or transmit the beam are matt black.

6. A transmitter unit for an open path gas detector that is configured to transmit a beam of radiation, the unit comprising
an enclosure (54) having an aperture (58) providing an optical path between the interior and the exterior of the enclosure
a transmitter of coherent radiation (50), e.g. a tuneable laser diode transmitter, located within the enclosure and
an optical device located within the enclosure that is configured to receive the radiation emitted by the transmitter and focus it on the aperture, thereby forming a beam of radiation passing out of the enclosure.

7. A transmitter unit as claimed in claim 6, wherein the diameter of the aperture is less than 200 µm, e.g. less than 100 µm, such as about 50µm.

8. A transmitter unit as claimed in claim 6 or claim 7, wherein the optical device is a lens or a mirror.

9. A transmitter unit as claimed in claim 6 or claim 7, wherein the optical device is a lens.

10. An open path gas detector comprising a transmitter unit as claimed in any one of claims 1 to 9.
